# EUROPEAN PATENT APPLICATION

(11) **EP 2 626 912 A1**
(43) Date of publication of application: **14.08.2013**
(21) Application number: 11830696.8
(22) Date of filing: 05.10.2011
(51) Int. Cl.: H01L 31/042, B32B 27/30

(54) **PROTECTIVE SHEET FOR SOLAR CELL MODULE, AND SOLAR CELL MODULE**

(30) Priority: 07.10.2010 JP 2010227512
(71) Applicant: LINTEC Corporation, Tokyo 173-0001 (JP)
(72) Inventor: TAKANASHI Yasunari, Tokyo 173-0001 (JP)
(74) Representative: Jansen, Cornelis Marinus
(86) International application number: PCT/JP2011/072973
(87) International publication number: WO 2012/046764

(57) **Abstract**

The present invention can provide a protective sheet for a solar cell module that is able to adequately ensure adhesive strength between a base film and a fluororesin layer over a long period of time, and a solar cell module provided therewith.

The protective sheet for a solar cell module of the present invention comprising a base film, a thermal adhesive resin layer directly adhered on at least one side of the base film and composed of a thermal adhesive resin having a functional group, and a fluororesin layer directly adhered on the thermal adhesive resin layer and composed of a fluororesin having a functional group capable of forming a chemical bond by reacting with the functional group of the thermal adhesive resin.

## Description

### TECHNICAL FIELD

The present invention relates to a protective sheet for a solar cell module used as a front protective sheet or a back protective sheet of a solar cell module, and a solar cell module provided therewith.
The present application claims priority on the basis of Japanese Patent Application No. 2010-227512 filed in Japan on October 7, 2010, the contents of which are incorporated herein by reference.

### BACKGROUND ART

Solar cell modules convert light energy from the sun to electrical energy, and are attracting attention as a clean energy source capable of generating electricity without emitting carbon dioxide in order to accommodate environmental issues such as air pollution or global warming.
In general, solar cell modules are generally composed of solar cells that carry out photoelectric conversion, an encapsulation material (filling layer) laminated on both sides of the solar cells, a front protective sheet (front sheet) laminated on the front side of the encapsulation material, and a back protective sheet (back sheet) laminated on the back side of the encapsulation material.

The main components of a solar cell module consist of solar cells in the form of photovoltaic elements, an encapsulation material in the form of an electrical insulator that prevents shorting of electrical circuits, and protective sheets that cover these components. A front protective sheet and a back protective sheet are respectively adhered to the light receiving side (front side) and back side of this solar cell module. In order to impart weather resistance and durability to solar cell modules so that they are able to withstand long-term indoor as well as outdoor use, it is necessary to protect the solar cells and encapsulation material from heavy rain, humidity, dust or mechanical impacts and the like, as well as maintain the inside of the solar cell module in a sealed state isolated from the outside air. Consequently, there is a need for a protective sheet for a solar cell module that has superior weather resistance.

The configuration of a typical protective sheet for a solar cell module frequently consists of laminating a polyvinyl fluoride resin film for imparting weather resistance and durability on a base film. However, polyvinyl fluoride films have the shortcomings of being expensive and being difficult to acquire as a result of being in short supply. Therefore, it has been proposed to form a similar layer with a fluororesin coating material on a base film such as a polyester film as an alternative to the use of a polyvinyl fluoride resin film. However, in the case of forming a fluororesin layer by coating and curing an ordinary fluororesin coating material on a base film, adequate adhering between the fluororesin layer and the base film is unable to be obtained, thereby resulting in the problem of increased susceptibility to separation. In order to solve this problem, technologies have been proposed in, for example, Patent Documents 1 and 2 that use a fluororesin having high adhesive strength with other materials.

Patent Document 1 (International Publication No. WO 2006/134764) discloses a fluororesin multilayer laminate obtained by directly laminating a fluororesin layer containing a functional group such as an acid anhydride residue and a thermal adhesive resin layer having a functional group such as an epoxy group by means such as a co-extrusion.
Patent Document 2 (Japanese Unexamined Patent Application Publication of PCT Application No. 2005-534520) discloses a multilayer film obtaining by laminating arbitrary components in the form of a protective layer (A), a layer (B) composed of a fluoropolymer and a functionalized polymer composed of alkyl (meth)acrylate units, a layer (C) having for a base thereof an ethylene-alkyl (meth)acrylate-unsaturated epoxide copolymer, and a polyolefin adhesive layer (D) by co-extrusion and the like.

### DOCUMENTS OF RELATED ART

### PATENT DOCUMENTS

Patent Document 1: International Publication No. WO 2006/134764
Patent Document 2: Japanese Unexamined Patent Application Publication of PCT Application No. 2005-534520

### DISCLOSURE OF THE INVENTION

### PROBLEMS TO BE SOLVED BY THE INVENTION

A protective sheet for a solar cell module is required to have adequate weather resistance, water resistance and the like in order to withstand long-term outdoor use, and in order to accomplish this, adhesive strength between a base film and a fluororesin layer must be adequately ensured over a long period of time. Polyethylene terephthalate (PET) is mainly used for the aforementioned base film.

However, Patent Documents 1 and 2 do not provide adequate descriptions of the adhesiveness of the aforementioned laminated film to the base film such as PET, and do not provide any description whatsoever regarding the configuration of each resin layer for which adequate adhesive strength is obtained in the case of laminating to a PET film, and particularly the configuration of each resin layer provided to adequately ensure adhesive strength between the base film and fluororesin layer over a long period of time.

With the foregoing in view, an object of the present invention is to provide a protective sheet for a solar cell module capable of adequately ensuring adhesive strength between a base film and a fluororesin layer over a long period of time, and to a solar cell module that uses that protective sheet.

### Means for Solving the Problems

In order to achieve the aforementioned obj ect, the present invention provides a protective sheet for a solar cell module having a base film, a thermal adhesive resin layer directly adhered on at least one side of the base film and composed of a thermal adhesive resin having a functional group, and a fluororesin layer directly adhered on the thermal adhesive resin layer and composed of a fluororesin having a functional group capable of forming a chemical bond by reacting with the functional group of the aforementioned thermal adhesive resin.

The base film that has adequate electrical insulating properties, weather resistance and moisture resistance for practical use as a protective sheet for a solar cell module, enables the aforementioned thermal adhesive resin layer to be laminated thereon, and is suitably selected from among various types of resin films typically used as resin films in a protective sheet for a solar cell module, can be used for the aforementioned base film.

Examples of resin films used for the aforementioned base film include resin films or sheets composed of resins such as polyolefin-based resins such as polyethylene or polypropylene, polyester-based resins such as polyethylene terephthalate (PET), polybutylene terephthalate (PBT) or polyethylene naphthalate (PEN), polyamide-based resins, polyimide-based resins, polycarbonate-based resins, polystyrene-based resins, polyvinyl alcohol-based resins, vinyl alcohol-based resins such as ethylene-vinyl acetate copolymer (EVA), polyphenylene oxide-based resins, polyphenylene sulfide-based resins, acrylonitrile-based resins, vinyl chloride-based resins, vinyl acetal-based resins, vinyl butyral-based resins or fluororesins. Among these resin films, films composed of polyester are preferable, and more specifically, PET film is preferable.

The thickness of the aforementioned base film is suitably determined based on the electrical insulating properties required by the solar cell module. For example, in the case the base film is a resin film, the thickness thereof is preferably within the range of 10 µm to 300 µm. More specifically, in the case the base film is a PET film, the thickness thereof is preferably within the range of 10 µm to 300 µm, more preferably within the range of 20 µm to 250 µm, and particularly preferably within the range of 30 µm to 200 µm, from the viewpoints of light weight and electrical insulating properties.

The aforementioned thermal adhesive resin layer is composed of a thermal adhesive resin having a functional group capable of chemically bonding with a functional group possessed by the aforementioned fluororesin layer, and is directly adhered to the surface of the base film. Examples of this thermal adhesive resin include polyethylenes such as low-density polyethylene (LDPE, density: 0.910 g/cm³ or more and less than 0.930 g/cm³), medium-density polyethylene (MDPE, density: 0.930 g/cm³ or more and less than 0.942 g/cm³) or high-density polyethylene (HDPE, density: 0.942 g/cm³ or more), polypropylene (PP), olefin-based elastomers (TPO), cycloolefin-based resins, ethylene-vinyl acetate copolymers (EVA), ethylene-vinyl acetate-maleic anhydride copolymers, ethylene-(meth)acrylic acid copolymers and ethylene-(meth)acrylic acid ester-maleic anhydride copolymers, and among these, polyolefin-based resins such as polyethylene are preferable.

A functional group capable of chemically bonding with a functional group possessed by the aforementioned fluororesin is selected for the functional group contained in the aforementioned thermal adhesive resin layer. In the case the functional group possessed by the aforementioned fluororesin is an acid anhydride residue, examples of the functional group contained in the thermal adhesive resin layer include a glycidyl group, amino group, epoxy group and isocyanate group. The content of the functional group in the aforementioned thermal adhesive resin is preferably within the range of 0.01 mol% to 10 mol% (where, mol% refers to a value calculated according to (number of moles of functional group/number of moles of all repeating units in thermal adhesive resin) × 100), and more preferably within the range of 0.05 mol% to 5 mol%.

In the case the functional group possessed by the aforementioned fluororesin is an acid anhydride residue, the functional group contained in the thermal adhesive resin layer is preferably a glycidyl group. Moreover, a thermal adhesive resin layer having a glycidyl group is preferably an ethylene-glycidyl methacrylate copolymer.
A preferable example of a commercially available product of this ethylene-glycidyl methacrylate copolymer is "LotaderAX8840" (trade name, Arkema K.K.).

The aforementioned fluororesin layer is composed of a fluororesin having a functional group capable of chemically bonding with a functional group contained in the aforementioned thermal adhesive resin layer, and is directly adhered to the surface of the aforementioned thermal adhesive resin layer. Examples of the aforementioned fluororesin include tetrafluoroethylene-perfluoro(alkyl vinyl ether)-based copolymers, tetrafluoroethylene-hexafluoropropylene-based copolymers, tetrafluoroethylene-perfluoro(alkyl vinyl ether)-hexafluoropropylene-based copolymers, ethylene-tetrafluoroethylene-based copolymers (ETFE), ethylene-chlorotrifluoroethylene-based copolymers, and ethylene-tetrafluoroethylene-hexafluoropropylene-based copolymers. In a particularly preferred embodiment of the present invention, the aforementioned fluororesin is preferably that composed of one or both of ethylene-tetrafluoroethylene-based copolymer and ethylene-tetrafluoroethylene-hexafluoropropylene-based copolymer.

Examples of the functional group contained in the aforementioned fluororesin include an acid anhydride residue, carboxyl group, epoxy group and acid halide group. Among these functional groups, an acid anhydride residue is preferable from the viewpoints of stronger adhesive strength between the fluororesin layer and thermal adhesive resin layer and being able to maintain a high level of adhesive strength over a long period of time. The content of the functional group in the aforementioned fluororesin is preferably within the range of 0.01 mol% to 10 mol% (where, mol% refers to a value calculated according to (number of moles of functional group/number of moles of all repeating units in thermal adhesive resin) × 100), and more preferably within the range of 0.05 mol% to 5 mol%.

This fluororesin containing an acid anhydride residue can be obtained by supplying a fluorine-containing monomer composing the aforementioned fluorine resin, another monomer such as an ethylene monomer and a functional group-containing monomer to a reaction vessel, and carrying out a copolymerization reaction in the presence of a polymerization initiator. Examples of functional group-containing monomers include maleic anhydride, itaconic anhydride and citraconic anhydride. A copolymerization method that uses a commonly used radical polymerization initiator and chain transfer agent can be employed for this copolymerization reaction. Examples of copolymerization methods include conventionally known bulk polymerization, solution polymerization, suspension polymerization and emulsion polymerization.

Examples of polymerization initiators used in this polymerization include peroxides such as pivaloyl tert-butyl peroxide, azo compounds such as azobisisobutyronitrile, and peroxyisobutyrates such as diisopropylperoxy dicarbonate.

Examples of media of solution polymerization include organic solvents such as fluorohydrocarbons, chlorofluorohydrocarbons, alcohols or hydrocarbons, and aqueous solvents, and among these, fluorohydrocarbons are preferable.
Examples of chain transfer agents include chlorofluorohydrocarbons such as 1,3-dichloro-1,1,2,2,3- pentafluoropropane, and hydrocarbons such as pentane or hexane.

Although there are no particular limitations on the polymerization conditions, the polymerization temperature, for example, is preferably 0°C to 100°C and more preferably 30°C to 80°C. In addition, the polymerization pressure is preferably within the range of 0.1 MPa to 10 MPa and more preferably within the range of 0.5 MPa to 3 MPa. The polymerization time can be suitably set according to the polymerization temperature, polymerization pressure, types of monomers and the like, and normally is preferably about 1 hour to 30 hours.

The aforementioned thermal adhesive resin layer and the aforementioned fluororesin layer are preferably laminated on the surface of the aforementioned base film by co-extrusion. More preferably, the aforementioned thermal adhesive resin is charged into one extruder of a co-extrusion device, the aforementioned fluororesin is supplied to the other extruder, and the thermal adhesive resin layer and the fluororesin layer are laminated in that order on one side of the base film while moving the base film at a constant speed by T-die co-extrusion. Subsequently, the thermal adhesive resin layer and the fluororesin layer may also be laminated on the other side of the base film in the same manner.

As a result of the functional groups of the thermal adhesive resin layer and the fluororesin layer reacting and forming chemical bonds between their respective layers formed by the aforementioned co-extrusion, these layers are firmly adhered. In addition, the thermal adhesive resin layer is firmly thermally adhered to the surface of the base film. As a result, the fluororesin layer is firmly adhered to one or both sides of the base film through the thermal adhesive resin layer.

Although there are no particular limitations on the thicknesses of the aforementioned thermal adhesive resin layer and fluororesin layer in this protective sheet for a solar cell module, normally they are preferably each within the range of 10 µm to 200 µm and more preferably within the range of 15 µm to 150 µm.

Various types of additives such as pigment, ultraviolet absorber, ultraviolet stabilizer, flame retardant, plasticizer, antistatic agent, lubricant or anti blocking agent may be contained in the base film, thermal adhesive resin layer and fluororesin layer.
There are no particular limitations on the pigment provided it does not impair the effects of the present invention, and examples thereof include titanium dioxide, zinc oxide, aluminum oxide, silica and carbon black. White pigment is used particularly preferably for the pigment, and the type of pigment along with the residual amount in the layer in which it is contained are as described in the second and first embodiments to be subsequently described.
Examples of ultraviolet absorbers include benzophenone-based, benzotriazole-based, oxalic anilide-based, cyanoacrylate-based and triazine-based compounds.

In the protective sheet for a solar cell module of the present invention, the functional group of the aforementioned fluororesin is preferably an acid anhydride residue.

In the protective sheet for a solar cell module of the present invention, the aforementioned fluororesin is preferably composed of one or both of an ethylene-tetrafluoroethylene-based copolymer and ethylene-tetrafluoroethylene-hexafluoropropylene-based copolymer.

In the protective sheet for a solar cell module of the present invention, the functional group of the aforementioned thermal adhesive resin is preferably a glycidyl group.

In the protective sheet for a solar cell module of the present invention, the aforementioned thermal adhesive resin is preferably composed of a polyolefin-based resin.

In addition, the present invention provides a solar cell module comprising the use of the aforementioned protective sheet for a solar cell module.

### Effects of the Invention

As a result of the protective sheet for a solar cell module of the present invention being composed of a thermal adhesive resin layer, composed of a thermal adhesive resin having a functional group and directly adhered on at least one side of a base film, and a fluororesin layer, composed of a fluororesin having a functional group capable of forming a chemical bond by reacting with the functional group of the aforementioned thermal adhesive resin and directly adhered on the thermal adhesive resin layer, adhesive strength between the base film and the fluororesin layer can be adequately ensured over a long period of time, thereby making it possible to provide a protective sheet for a solar cell module having superior durability.

Since the solar cell module of the present invention uses the aforementioned protective sheet for a solar cell module according to the present invention for one side or both sides of a front protective sheet or back protective sheet, it is able to ensure superior weather resistance over a long period of time.

### BRIEF DESCRIPTION OF THE DRAWINGS

FIG. 1 is a schematic cross-sectional view showing a first embodiment of the protective sheet for a solar cell module of the present invention.
FIG. 2 is a schematic cross-sectional view showing a second embodiment of the protective sheet for a solar cell module of the present invention.
FIG. 3 is a schematic cross-sectional view showing a third embodiment of the protective sheet for a solar cell module of the present invention.
FIG. 4 is a schematic cross-sectional view showing a fourth embodiment of the protective sheet for a solar cell module of the present invention.
FIG. 5 is a schematic cross-sectional view showing a protective sheet for a solar cell module fabricated in Comparative Example 1.
FIG. 6 is a schematic cross-sectional view showing a protective sheet for a solar cell module fabricated in Comparative Example 2.
FIG. 7 is a schematic cross-sectional view showing a protective sheet for a solar cell module fabricated in Comparative Example 3.
FIG. 8 is a schematic cross-sectional view showing an embodiment of the solar cell module of the present invention.

### BEST MODE FOR CARRYING OUT THE INVENTION

The following provides an explanation of embodiments of the protective sheet for a solar cell module of the present invention and a solar cell module in which it is used with reference to the drawings.

### (1) First Embodiment

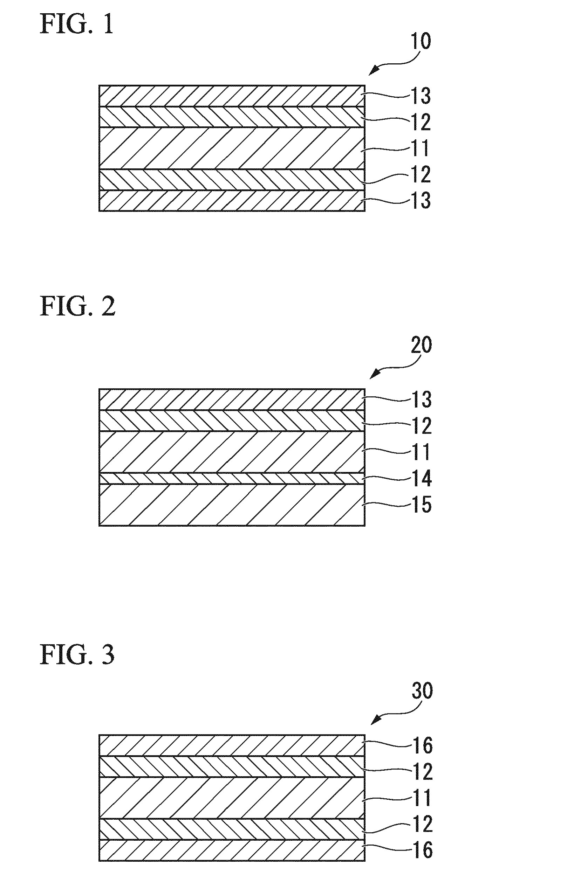

FIG. 1 is a schematic cross-sectional view showing a first embodiment of the protective sheet for a solar cell module of the present invention.
A protective sheet 10 for a solar cell module of this embodiment consists of thermal adhesive resin layers 12,12 composed of a thermal adhesive resin having a functional group and directly adhered onto both sides of a base film 11, and fluororesin layers 13,13 composed of a fluororesin having a functional group capable of forming a chemical bond by reacting with the functional group of the aforementioned thermal adhesive resin and directly adhered to the thermal adhesive resin layers 12,12.
This protective sheet 10 for a solar cell module is applied to a front protective sheet (to be referred to as a front sheet) or a back protective sheet (to be referred to as a back sheet) of a solar cell module.

Abase film 11 that has adequate electrical insulating properties, weather resistance and moisture resistance for practical use as a protective sheet for a solar cell module, enables the thermal adhesive resin layer 12 to be laminated thereon, and is suitably selected from among various types of resin films typically used as resin films in a protective sheet for a solar cell module, can be used for the base film 11.

Examples of resin films used for the base film 11 include resin films or sheets composed of resins such as polyolefin-based resins such as polyethylene or polypropylene, polyester-based resins such as polyethylene terephthalate (PET), polybutylene terephthalate (PBT) or polyethylene naphthalate (PEN), polyamide-based resins, polyimide-based resins, polycarbonate-based resins, polystyrene-based resins, polyvinyl alcohol-based resins, vinyl alcohol-based resins such as ethylene-vinyl acetate copolymer (EVA), polyphenylene oxide-based resins, polyphenylene sulfide-based resins, acrylonitrile-based resins, vinyl chloride-based resins, vinyl acetal-based resins, vinyl butyral-based resins or fluororesins. Among these resin films, films composed of polyester are preferable, and more specifically, PET film is preferable.

The thickness of the base film 11 is suitably set based on the electrical insulating properties required by the solar cell module. For example, in the case the base film 11 is a resin film, the thickness thereof is preferably within the range of 10 µm to 300 µm. More specifically, in the case the base film 11 is a PET film, the thickness thereof is preferably within the range of 10 µm to 300 µm, more preferably within the range of 20 µm to 250 µm, and particularly preferably within the range of 30 µm to 200 µm, from the viewpoints of light weight and electrical insulating properties.

The aforementioned thermal adhesive resin layer 12 is composed of a thermal adhesive resin having a functional group capable of chemically bonding with the functional group possessed by the aforementioned fluororesin, and is directly adhered to the surface of the base film 11. Examples of this thermal adhesive resin include polyethylenes such as lowr-density polyethylene (LDPE, density: 0.910 g/cm³ or more and less than 0.930 g/cm⁻³), medium-density polyethylene (MDPE, density: 0.930 g/cm³ or more and less than 0.942 g/cm³) or high-density polyethylene (HDPE, density: 0.942 g/cm³or more), polypropylene (PP), olefin-based elastomers (TPO), cycloolefin-based resins, ethylene-vinyl acetate copolymers (EVA), ethylene-vinyl acetate-maleic anhydride copolymers, ethylene-(meth)acrylic acid copolymers and ethylene-(meth)acrylic acid ester-maleic anhydride copolymers, and among these, polyolefin-based resins such as polyethylene are preferable.

A functional group capable of chemically bonding with a functional group possessed by the aforementioned fluororesin is selected for the functional group contained in the thermal adhesive resin layer 12. In the case the functional group possessed by the aforementioned fluororesin is an acid anhydride residue, examples of the functional group contained in the thermal adhesive resin layer 12 include a glycidyl group, amino group, epoxy group and isocyanate group. The content of the functional group in the aforementioned thermal adhesive resin is preferably within the range of 0.01 mol% to 10 mol% (where, mol% refers to a value calculated according to (number of moles of functional group/number of moles of all repeating units in thermal adhesive resin) x 100), and more preferably within the range of 0.05 mol% to 5 mol%.

In a particularly preferred embodiment of the present invention, in the case the functional group possessed by the aforementioned fluororesin is an acid anhydride residue, the functional group contained in the thermal adhesive resin layer 12 is a glycidyl group. Moreover, an ethylene-glycidyl methacrylate copolymer is preferably used for the thermal adhesive resin layer 12 having a glycidyl group.
A preferable example of a commercially available product of this ethylene-glycidyl methacrylate copolymer is "Lotader AX8840" (trade name, Arkema K.K.).

The aforementioned fluororesin layer 13 is composed of a fluororesin having a functional group capable of chemically bonding with a functional group contained in the aforementioned thermal adhesive resin layer 12, and is directly adhered to the surface of the aforementioned thermal adhesive resin layer 12. Examples of the aforementioned fluororesin include tetrafluoroethylene-perfluoro(alkyl vinyl ether)-based copolymers, tetrafluoroethylene-hexafluoropropylene-based copolymers, tetrafluoroethylene-perfluoro(alkyl vinyl ether)-hexafluoropropylene-based copolymers, ethylene-tetrafluoroethylene-based copolymers (ETFE), ethylene-chlorotrifluoroethylene-based copolymers, and ethylene-tetrafluoroethylene-hexafluoropropylene-based copolymers. In a particularly preferred embodiment of the present invention, the aforementioned fluororesin is preferably that composed of one or both of ethylene-tetrafluoroethylene-based copolymer and ethylene-tetrafluoroethylene-hexafluoropropylene-based copolymer.

Examples of the functional group contained in the aforementioned fluororesin include an acid anhydride residue, carboxyl group, epoxy group and acid halide group. Among these functional groups, an acid anhydride residue is preferable from the viewpoints of stronger adhesive strength between the fluororesin layer 13 and the thermal adhesive resin layer 12 and being able to maintain a high level of adhesive strength over a long period of time. The content of the functional group in the aforementioned fluororesin is preferably within the range of 0.01 mol% to 10 mol% (where, mol% refers to a value calculated according to (number of moles of functional group/number of moles of all repeating units in thermal adhesive resin) × 100), and more preferably within the range of 0.05 mol% to 5 mol%.

This fluororesin containing an acid anhydride residue can be obtained by supplying a fluorine-containing monomer composing the aforementioned fluorine resin, another monomer such as an ethylene monomer and a functional group-containing monomer to a reaction vessel, and carrying out a copolymerization reaction in the presence of a polymerization initiator. Examples of functional group-containing monomers include maleic anhydride, itaconic anhydride and citraconic anhydride. A copolymerization method that uses a commonly used radical polymerization initiator and chain transfer agent can be employed for this copolymerization reaction. Examples of copolymerization methods include conventionally known bulk polymerization, solution polymerization, suspension polymerization and emulsion polymerization.

Examples of polymerization initiators used in this polymerization include peroxides such as pivaloyl tert-butyl peroxide, azo compounds such as azobisisobutyronitrile, and peroxyisobutyrates such as diisopropylperoxy dicarbonate.

Examples of media of solution polymerization, include organic solvents such as fluorohydrocarbons, chlorofluorohydrocarbons, alcohols or hydrocarbons, and aqueous solvents, and among these, fluorohydrocarbons are preferable.
Examples of chain transfer agents include chlorofluorohydrocarbons such as 1,3-dichloro-1,1,2,2,3- pentafluoropropane, and hydrocarbons such as pentane or hexane.

Although there are no particular limitations on the polymerization conditions, the polymerization temperature, for example, is preferably 0°C to 100°C and more preferably 30°C to 80°C. In addition, the polymerization pressure is preferably within the range of 0.1 MPa to 10 MPa and more preferably within the range of 0.5 MPa to 3 MPa. The polymerization time can be suitably set according to the polymerization temperature, polymerization pressure, types of monomers and the like, and normally is preferably about 1 hour to 30 hours.

The aforementioned thermal adhesive resin layer 12 and the aforementioned fluororesin layer 13 are preferably laminated on the surface of the aforementioned base film 11 by co-extrusion. More preferably, the aforementioned thermal adhesive resin is charged into one extruder of a co-extrusion device, the aforementioned fluororesin is supplied to the other extruder, and the thermal adhesive resin layer 12 and the fluororesin layer 13 are laminated in that order on one side of the base film 11 while moving the base film 11 at a constant speed by T-die co-extrusion. Subsequently, the protective sheet 10 for a solar cell module having the configuration shown in FIG. 1 is produced by laminating the thermal adhesive resin layer 12 and the fluororesin layer 13 on the other side of the base film 11 in the same manner.

As a result of the functional groups of the thermal adhesive resin layer 12 and the fluororesin layer 13 reacting and forming chemical bonds between their respective layers formed by the aforementioned co-extrusion, these layers are firmly adhered. In addition, the thermal adhesive resin layer 12 is firmly thermally adhered to the surface of the base film 11. As a result, the fluororesin layers 13,13 are firmly bonded to both sides of the base film 11 through the thermal adhesive resin layers 12,12.

Although there are no particular limitations on the thicknesses of the aforementioned thermal adhesive resin layer 12 and fluororesin layer 13 in this protective sheet 10 for a solar cell module, normally they are preferably each within the range of 10 µm to 200 µm and more preferably within the range of 15 µm to 150 µm.

Various types of additives such as pigment, ultraviolet absorber, ultraviolet stabilizer, flame retardant, plasticizer, antistatic agent, lubricant or anti blocking agent may be contained in the base film 11, the thermal adhesive resin layer 12 and the fluororesin layer 13.
There are no particular limitations on the pigment provided it does not impair the effects of the present invention. Examples thereof include titanium dioxide and carbon black. Examples of ultraviolet absorbers include benzophenone-based, benzotriazole-based, oxalic anilide-based, cyanoacrylate-based and triazine-based compounds.

As a result of the protective sheet 10 for a solar cell module of the present embodiment being composed of the thermal adhesive resin layers 12,12, composed of a thermal adhesive resin having a functional group and directly adhered on both sides of the base film 11, and the fluororesin layers 13, composed of a fluororesin having a functional group capable of forming a chemical bond by reacting with the functional group of the aforementioned thermal adhesive resin and directly adhered on the thermal adhesive resin layers 12,12, adhesive strength between the base film 11 and the fluororesin layer 13 can be adequately ensured over a long period of time, thereby making it possible to provide a protective sheet for a solar cell module having superior durability.
Furthermore, although the protective sheet 10 for a solar cell module of the present embodiment is composed by respectively laminating the thermal adhesive resin layers 12,12 and the fluororesin layers 13,13 on both sides of the base film 11, it may also be composed by laminating the thermal adhesive resin layer 12 and the fluororesin layer 13 only on one side of the base film 11.

### (Second Embodiment)

FIG. 2 is a schematic cross-sectional view showing a second embodiment of the protective sheet for a solar cell module of the present invention.
In FIG. 2, those constituent features that are the same as those of the protective sheet 10 for a solar cell module shown in FIG. 1 are indicated with the same reference symbols and explanations thereof are omitted.
A protective sheet 20 for a solar cell module of this embodiment is applied to a back sheet of a solar cell module.

The protective sheet 20 for a solar cell module of this embodiment consists of the aforementioned thermal adhesive resin layer 12 directly adhered onto one side of the base film 11, and the aforementioned fluororesin layer 13 directly bonded to the thermal adhesive resin layer 12, and a white thermal adhesive layer 15 laminated on the other side of the base film 11 through an adhesive layer 14.

Examples of adhesive agents used to compose the aforementioned adhesive layer 14 include polyacrylic-based adhesive agents, polyurethane-based adhesive agents, epoxy-based adhesive agents, polyester-based adhesive agents and polyester polyurethane-based adhesive agents. One type of these adhesive agents may be used alone or two or more types may be used in combination.

The aforementioned white thermal adhesive layer 15 serves as a thermal adhesive layer used to adhere with an encapsulation material that composes the solar cell module. Here, thermal adhesiveness refers to a property whereby adhesiveness is demonstrated as a result of being subjected to heat treatment. The temperature of heat treatment for demonstrating adhesiveness is preferably within the range of 50°C to 200°C. In addition, this white thermal adhesive layer 15 is also intended to have a function that improves power generation efficiency of the solar cell module by adhering to the back side of the solar cell module, and reflecting light that has escaped from the solar cell module and returning it to the module side.

The aforementioned white thermal adhesive layer 15 is composed of a material in which a white pigment is uniformly dispersed in a base thermal adhesive resin. Examples of this thermal adhesive resin include polyethylene resins such as low-density polyethylene (LDPE, density: 0.910 g/cm³ or more and less than 0.930 g/cm³), medium-density polyethylene (MDPE, density: 0.930 g/cm³ or more and less than 0.942 g/cm³) or high-density polyethylene (HDPE, density: 0.942 g/cm³ or more), polypropylene (PP), olefin-based elastomers (TPO), cycloolefin resins and ethylene-vinyl acetate copolymers (EVA). Among these, EVA is preferable from the viewpoint of allowing the obtaining of favorable thermal adhesiveness with the encapsulation material of the solar cell module.

There are no particular limitations on the white pigment contained in the aforementioned white thermal adhesive layer 15 provided it does not impair the effects of the present invention, and examples of white pigments used include titanium dioxide, zinc oxide, aluminum oxide and silica. Specific examples include titanium dioxide, rutile titanium dioxide treated with silicon oxide for imparting durability in the form of "Ti-Pure R105" (trade name, Du Pont Corp.), and hydrophobic silica, in which hydroxyl groups on the surface of silica are modified by surface treatment with dimethyl silicone, in the form of "Cab-O-Sil TS 720" (trade name, Cabot Corp.). The content of white pigment contained in this white thermal adhesive layer is preferably 2.5% by weight to 35% by weight.

There are no particular limitations on the thickness of the aforementioned white thermal adhesive layer 15 provided it does not impair the effects of the present invention, is preferably within the range of, for example, 1 µm to 200 µm, more preferably within the range of 10 µm to 200 µm, and even more preferably within the range of 15 µm to 150 µm, from the viewpoint of light weight and electrical insulating properties.

The protective sheet 20 for a solar cell module of the present embodiment allows the same effects to be obtained as the protective sheet 10 for a solar cell module of the aforementioned first embodiment, and is able to improve adhesiveness to the encapsulation material of the solar cell module as a result of being provided with the white thermal adhesive layer 15. Thus, as a result of applying the protective sheet 20 for a solar cell module of the present embodiment to a solar cell module, there is less susceptibility of separation from the encapsulation material of the solar cell module, and a solar cell module can be provided that has superior weather resistance over a long period of time.

### (Third Embodiment)

FIG. 3 is a schematic cross-sectional view showing a third embodiment of the protective sheet for a solar cell module of the present invention.
In FIG. 3, those constituent features that are the same as those of the protective sheet 10 for a solar cell module shown in FIG. 1 are indicated with the same reference symbols and explanations thereof are omitted.
A protective sheet 30 for a solar cell module of this embodiment is applied to a back sheet of a solar cell module.

The protective sheet 30 for a solar cell module of this embodiment consists of the thermal adhesive resin layers 12,12 composed of a thermal adhesive resin having a functional group and directly adhered onto both sides of the base film 11, and white fluororesin layers 16,16, composed of a fluororesin containing a white pigment and having a functional group capable of forming a chemical bond by reacting with the functional group of the thermal adhesive resin, directly bonded to the thermal adhesive resin layers 12,12.

The aforementioned white fluororesin layer 16 uses the same fluororesin as the fluororesin in the protective sheet 10 for a solar cell module of the aforementioned first embodiment, and is formed with material in which a white pigment such as titanium dioxide as described in the aforementioned second embodiment is uniformly dispersed therein. A master batch, in which a white pigment is preliminarily incorporated and uniformly dispersed in a base resin such as a fluororesin, is preferably used to uniformly disperse the white pigment in the aforementioned fluororesin. The content of white pigment contained in this white fluororesin layer is preferably 2.5% by weight to 50% by weight.

This protective sheet 30 for a solar cell module is preferably produced by laminating the thermal adhesive resin layer 12 and the white fluororesin layer 16 on the surface of the aforementioned base film 11 by co-extrusion using the same production method as that of the protective sheet 10 for a solar cell module of the aforementioned first embodiment.

The protective sheet 30 for a solar cell module of this embodiment is able to adequately ensure adhesive strength between the base film 11 and the white fluororesin layer 16 over a long period of time in the same manner as the protective sheet 10 for a solar cell module of the aforementioned first embodiment, and is able to provide a protective sheet for a solar cell module having superior durability. In addition, as a result of using the white fluororesin layer 16, power generation efficiency of the solar cell module can be improved by adhering to the back side of the solar cell module, and reflecting light that has escaped from the solar cell module and returning it to the module side.

### (Fourth Embodiment)

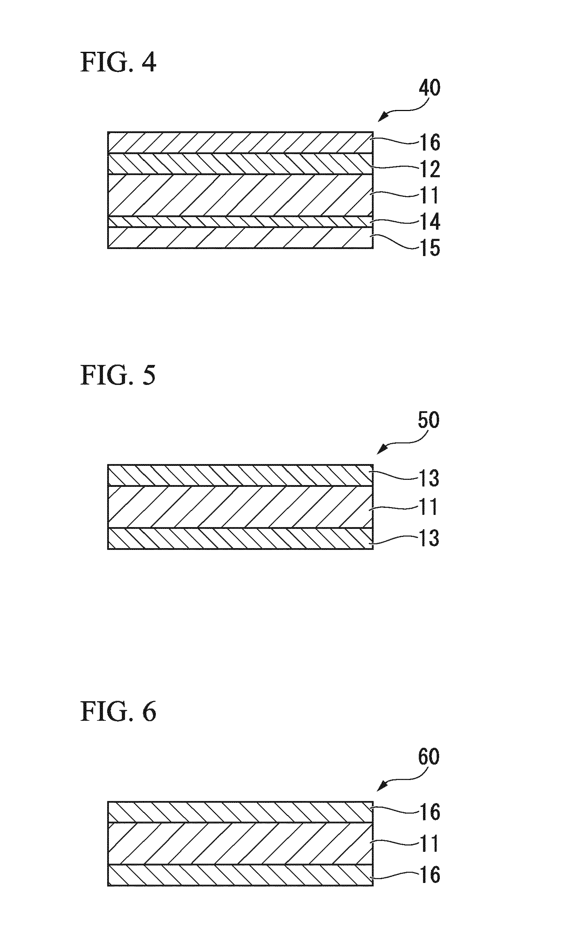

FIG. 4 is a schematic cross-sectional view showing a fourth embodiment of the protective sheet for a solar cell module of the present invention.
In FIG. 4, those constituent features that are the same as those of the protective sheets 10 to 30 for a solar cell module shown in FIGS. 1 to 3 are indicated with the same reference symbols and explanations thereof are omitted.
A protective sheet 40 for a solar cell module of this embodiment is applied to a back sheet of a solar cell module.

The protective sheet 40 for a solar cell module of this embodiment consists of the aforementioned thermal adhesive resin layer 12 directly adhered onto one side of the base film 11, the aforementioned white fluororesin layer 16 directly adhered to the thermal adhesive resin layer 12, and the aforementioned white thermal adhesive layer 15 laminated on the other side of the base film 11 through the aforementioned adhesive layer 14.

The protective sheet 40 for a solar cell module of this embodiment is able to adequately ensure adhesive strength between the base film 11 and the white fluororesin layer 16 over a long period of time in the same manner as the protective sheet 10 for a solar cell module of the aforementioned first embodiment, and is able to provide a protective sheet for a solar cell module having superior durability. In addition, as a result of using the white thermal adhesive layer 15, power generation efficiency of the solar cell module can be improved by adhering to the back side of the solar cell module, and reflecting light that has escaped from the solar cell module and returning it to the module side.

Furthermore, the configurations of each of the protective sheets 10, 20, 30 and 40 for a solar cell module as previously described are merely intended to be examples of the present invention, and the present invention is not limited thereto. Each of the protective sheets 10, 20, 30 and 40 for a solar cell module can be modified and altered in various ways.
For example, a vapor-deposited film composed of an inorganic material such as a metal or metalloid, or oxide, nitride or silicide and the like of a metal or metalloid, may be formed on one or both sides of the base film 11 in order to improve moisture resistance or weather resistance and the like.

### (Solar Cell Module)

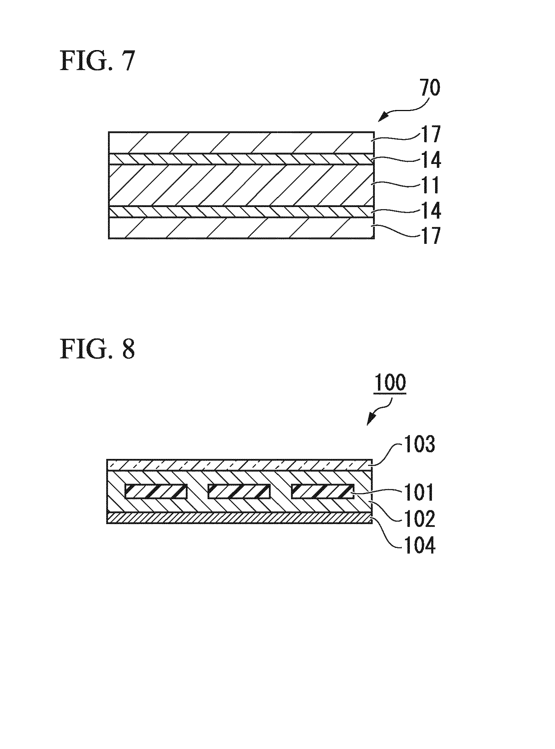

FIG. 8 is a schematic cross-sectional view showing an embodiment of the solar cell module of the present invention.
A solar cell module 100 is roughly composed of solar cells 101 composed of crystalline silicon or amorphous silicon and the like, an encapsulation material (filler layer) 102 composed of an electrical insulator that encapsulates the solar cells 101, a front protective sheet (front sheet) 103 laminated on the surface of the encapsulation material 102, and a back protective sheet (back sheet) 104 laminated on the back of the encapsulation material 102.

In this embodiment, the solar cell module 100 has the protective sheet 10, 20, 30 or 40 for a solar cell module according to the aforementioned first to fourth embodiments provided for the front sheet 103 or the back sheet 104.

As a result of composing a solar cell module by applying the protective sheet 10, 20, 30 or 40 of the first to fourth embodiments for the front sheet or back sheet of the solar cell module, superior weather resistance can be ensured for the solar cell module 100 over a long period of time.

### Examples

### [polymerization of Fluororesin]

The inside of a polymerization reactor equipped with a stirrer was degassed, and 300.0 g of 1H-tridecafluorohexane, 75.0 g of 1,3-dichloro-1,1,2,2,3-pentafluoropropane (trade name: "HCFC-225 ", Wako Chemical, Ltd.) and 1.49 g of 3,3,4,4,5,5,6,6,6-nonafluoro-1-hexene were fed into the polymerization reactor. Moreover, 157.3 g of hexafluoropropane, 49.2 g of tetrafluoroethylene and 1.6 g of ethylene were injected into the polymerization reactor under pressure followed by raising the temperature thereof to 66°C. 0.564 g of pivaloyl tert-butyl peroxide as a polymerization initiator was then added to initiate polymerization. During polymerization, a monomer gas consisting of a mixture of tetrafluoroethylene and ethylene at a ratio of 54/46 was allowed to continuously flow into the polymerization reactor to maintain a constant pressure. Moreover, a monomer gas consisting of a mixture of tetrafluoroethylene and ethylene (mixing ratio: 54/46) and containing 1.0 mol% of 3,3,4,4,5,5,6,6,6- nonafluoro-1-hexene, 0.25 mol% of itaconic anhydride and 1% by weight of 1,3-dichloro-1,1,2,2,3-pentafluoropropane was allowed to continuously flow into the polymerization reactor. Subsequently, polymerization was discontinued at the point 70 g of the monomer mixed gas had been charged into the polymerization reactor, and the temperature of the polymerization reactor was allowed to cool to room temperature while simultaneously purging to normal pressure. The resulting fluororesin was dried for 24 hours at 120°C to obtain the target fluororesin.

### [Fabrication of White Fluororesin]

A master batch composed of ETFE and titanium dioxide (trade name: "H5150 White", Dainichiseika Color & Chemicals Mfg. Co., Ltd.) was added to the fluororesin obtained as described above and mixed so that the content of titanium dioxide was 20% by weight to obtain a white fluororesin.

### [Example 1]

Corona treatment (output: 2000 W) was carried out on one side of a base film in the form of a polyester film (trade name: "Teijin Tetron Film SL", thickness: 125 µm, Teijin-Du Pont Films, Inc.). Subsequently, the fluororesin fabricated as described above and an ethylene-glycidyl methacrylate copolymer (trade name: "Lotader AX8840", Arkema K.K.) as a functional group-containing thermal adhesive resin were respectively co-extruded to a thickness of 25 µm on the corona treated surface of the aforementioned base film with a T-die film formation device (cylinder temperature: 200°C, T-die temperature: 300°C). Moreover, the protective sheet 10 for a solar cell module was obtained having a configuration in which a fluororesin/ethylene-glycidyl methacrylate copolymer layer was fabricated on the other side of the base film using the same method, ethylene-glycidyl methacrylate copolymer layers (thermal adhesive resin layers 12,12) were directly adhered on both sides of the base film 11 as shown in FIG. 1, and fluororesin layers 13,13 were directly adhered on those layers.

### [Example 2]

Corona treatment (output: 2000 W) was carried out on one side of a base film in the form of a polyester film (trade name: "Teijin Tetron Film SL", thickness: 125 µm, Teijin-Du Pont Films, Inc.). Subsequently, the fluororesin fabricated as described above and an ethylene-glycidyl methacrylate copolymer (trade name: "Lotader AX8840", Arkema K.K.) as a functional group-containing thermal adhesive resin were respectively co-extruded to a thickness of 25 µm on the corona treated surface of the aforementioned base film with a T-die film deposition device (cylinder temperature: 200°C, T-die temperature: 300°C).
Moreover, an adhesive layer was formed at a thickness of 10 µm on the other side of the base film by coating an adhesive agent (mixture of "Takelac A-515" (trade name, Mitsui Chemicals Inc.) and "Takenate A-3" (trade name, Mitsui Chemicals Inc.) mixed at a ratio of 9:1) with a Mayer bar followed by drying for 1 minute at 80°C. As a result of laminating this adhesive layer and a white thermal adhesive layer in the form of an EVA film containing 5% by weight of titanium dioxide (thickness: 100 µm), as shown in Fig. 2, the protective sheet 20 for a solar cell module was fabricated having a configuration in which an ethylene-glycidyl methacrylate copolymer layer (thermal adhesive resin layer 12) was directly adhered on one side of the base film 11, the aforementioned fluororesin 13 was directly adhered on the thermal adhesive resin layer 12, and the white thermal adhesive layer 15 was laminated on the other side of the base film 11 through the adhesive layer 14.

### [Example 3]

The protective sheet 30 for a solar cell module having a configuration in which ethylene-glycidyl methacrylate copolymer layers (thermal adhesive resin layers 12,12) were directly adhered on both sides of the base film 11, and white fluororesin layers 16,16 were directly adhered on the thermal adhesive resin layers 12,12 as shown in FIG. 3 was fabricated in the same manner as Example 1 with the exception changing the fluororesin to white fluororesin.

### [Example 4]

The protective sheet 40 for a solar cell module having a configuration in which an ethylene-glycidyl methacrylate copolymer layer (thermal adhesive resin layer 12) was directly adhered onto one side of the base film 11, the white fluororesin layer 16 was directly adhered on the thermal adhesive resin layer 12, and the white thermal adhesive layer 15 was laminated on the other side of the base film 11 through the adhesive layer 14 as shown in FIG. 4 was fabricated in the same manner as Example 2 with the exception of changing the fluororesin to white fluororesin.

### [Comparative Example 1]

A protective sheet 50 for a solar cell module was fabricated having a configuration in which the fluororesin layers 13 were extrusion coated onto both sides of the base film 11 without providing the thermal adhesive layers 12, and the fluororesin layers 13, 13 were directly adhered onto both sides of the base film 11 as shown in FIG. 5.

### [Comparative Example 2]

A protective sheet 60 for a solar cell module having a configuration in which the white fluororesin layers 16,16 were directly adhered on both sides of the base film 11 as shown in FIG. 6 was fabricated in the same manner as Comparative Example 1 with the exception of changing the fluororesin to white fluororesin.

### [Comparative Example 3]

The adhesive layer 14 was formed at a thickness of 10 µm by coating an adhesive agent (mixture of "Takelac A-515" (trade name, Mitsui Chemicals Inc.) and "Takenate A-3" (trade name, Mitsui Chemicals Inc.) mixed at a ratio of 9:1) on one side of a base film in the form of a polyester film (trade name: "Teijin Tetron Film SL", thickness: 125 µm, Teijin-Du Pont Films, Inc.) with a Mayer bar followed by drying for 1 minute at 80°C. This adhesive layer 14, 14 was then laminated with an ETFE film 17 (trade name: "Aflex 25WP", thickness: 25 µm, Asahi Glass Co., Ltd.). Moreover, the ETFE film 17 was also laminated on the other side of the base film through the adhesive layer using the same method to fabricate a protective sheet 70 for a solar cell module having a configuration in which the ETFE films 17,17 are laminated on both sides of the base film 11 through the adhesive layers 14 as shown in FIG. 7.

The protective sheets for a solar module of Examples 1 to 4 and Comparative Examples 1 to 3 fabricated in the manner described above (to be referred to as the protective sheets) were measured and evaluated for peel adhesive strength, breaking strength and yellowness index ΔYI in accordance with the measuring and evaluation methods indicated below.
Furthermore, peel adhesive strength and breaking strength were measured for protective sheets before and after the durability test indicated below followed by a comparison of those results.
In addition, yellowness index ΔYI was measured for protective sheets after the durability test indicated below.
The results are summarized in Table 1.

### <Durability Test>

Each protective sheet was exposed for 24 hours to conditions consisting of a temperature of 121 °C, humidity of 100% RH and pressure of 2 atm.

### <Weather Resistance Test (UV Withstand Test)>

Using a weather resistance tester, Testing under conditions consisting of irradiating with UV light for 4 hours (black panel temperature: 63°C, humidity: 70%), resting for 4 hours (black panel temperature: 70°C, humidity: 90%), spraying for 10 seconds, dew cycle of 4 hours (black panel temperature: 30°C, humidity: 100%) and spraying for 10 seconds was repeated for 100 hours using a weather resistance tester (trade name: "EYE Super UV Tester SUV-W13", Iwasaki Electric Co., Ltd.), followed by measuring yellowness index ΔYI by placing each of the protective sheets under these repeating conditions.

### <Peel Strength>

Each protective sheet was cut to a size of 25 mm × 150 mm followed by testing peel strength between the polyester film and fluororesin layer in compliance with JIS K6854-3: 1999 (Adhesives - Determination of peel strength of bonded assemblies- Part 3: Adhesive-180 ° peel test for flexible-to-flexible bonded assemblies (T-Peel test)). The peeling speed was set to 300 mm/min.

### <Breaking Strength>

Each protective sheet was cut to a size of 15 mm x 150 mm followed by measuring the load when the protective sheet breaks in compliance with JIS K7127: 1999 (Plastics - Determination of tensile properties - Part 3: Test conditions for films and sheets).

### <Yellowness Index ΔYI>

Yellowness index ΔYI of the protective sheets after weather resistance testing was measured in compliance with JIS K7373: 2006 (Plastics - Determination of yellowness index and change of yellowness index).

**[Table 1]**

| | Peel strength (N/25 mm) | | Breaking strength (N/15 mm) | | Yellowness index ΔYI |
|---|---|---|---|---|---|
| | Before durability test | After durability test | Before durability test | After durability test | After weather resistance test |
| Ex.1 | Unpeelable¹⁾ | Unpeelable¹⁾ | 333 | 270 | 42 |
| Ex.2 | Unpeelable¹⁾ | Unpeelable¹⁾ | 340 | 264 | 38 |
| Ex.3 | Unpeelable¹⁾ | Unpeelable¹⁾ | 337 | 261 | 0.46 |
| Ex.4 | Unpeelablel¹⁾ | Unpeelable¹⁾ | 330 | 266 | 0.50 |
| Comp.Ex.1 | 0.5 | Immeasurable²⁾ | 311 | 211 | 46 |
| Comp.Ex.2 | 0.2 | Immeasurable ²⁾ | 318 | 217 | 0.63 |
| Comp.Ex.3 | 14.8 | 7.0 | 321 | 242 | 0.77 |

1) Extremely strong adhesive strength that prevented peeling.
2) Extremely weak adhesive strength causing the occurrence of peeling during the durability test.

Based on the results shown in Table 1, the protective sheets of Examples 1 to 4 according to the present invention were determined to have superior adhesive strength between the base film and fluororesin layer and be able to maintain a high level of adhesive strength over a long period of time.
In addition, the protective sheets of Examples 1 to 4 according to the present invention were also determined to be able to maintain superior breaking strength over a long period of time.

### INDUSTRIAL APPLICABILITY

The present invention relates to a protective sheet used as a front protective sheet or back protective sheet of a solar cell module, and to a solar cell module provided therewith. The protective sheet of the present invention is able to adequately ensure adhesive strength between a base film and a fluororesin layer over a long period of time.

### BRIEF DESCRIPTION OF THE REFERENCE SYMBOLS

11: Base film
12: Thermal adhesive resin layer
13: Fluororesin layer
14: Adhesive layer
15: White thermal adhesive layer
16: White fluororesin layer
17: ETFE film
100: Solar cell module
101: Solar cell
102: Encapsulation material
103: Front protective sheet (front sheet)
104: Back protective sheet (back sheet)

## Claims

1. A protective sheet for a solar cell module, comprising: a base film, a thermal adhesive resin layer directly adhered on at least one side of the base film and composed of a thermal adhesive resin having a functional group, and a fluororesin layer directly adhered on the thermal adhesive resin layer and composed of a fluororesin having a functional group capable of forming a chemical bond by reacting with the functional group of the thermal adhesive resin.

2. The protective sheet for a solar cell module according to claim 1, wherein the functional group of the fluororesin is an acid anhydride residue.

3. The protective sheet for a solar cell module according to claim 1, wherein the fluororesin is composed of one or both of ethyl ene-tetrafluoroethylene-based copolymer and ethylene- tetrafluoroethylene-hexafluoropropylene-based copolymer.

4. The protective sheet for a solar cell module according to claim 1, wherein the functional group of the thermal adhesive resin is a glycidyl group.

5. The protective sheet for a solar cell module according to claim 1, wherein the thermal adhesive resin is composed of a polyolefin-based resin.

6. A solar cell module having the protective sheet for a solar cell module according to claim 1.
